# FASCICULE DE BREVET EUROPEEN

(11) **EP 2 393 173 B1**
(45) Date de publication et mention de la délivrance du brevet: **13.02.2013**
(21) Numéro de dépôt: 11354019.9
(22) Date de dépôt: 10.05.2011
(51) Int. Cl.: H02B 11/28, G01R 1/02

(54) **Cellule électrique avec dispositifs de test dielectrique des cables et mise à la terre**
Elektrische Zelle mit dielektrischer Kabeltestvorrichtung und Erdungsvorrichtung
Electric cell with arrangement for dielectric cable test and earthing arrangement

(30) Priorité: 03.06.2010 FR 1002344
(43) Date de publication de la demande: 07.12.2011
(73) Titulaire: Schneider Electric Industries SAS, 92500 Rueil-Malmaison (FR)
(72) Inventeur: Perrone, Michel, 38050 Grenoble Cedex 09 (FR)
(74) Mandataire: Colette, Marie-Françoise

(56) Documents cités:
- EP-A2- 0 176 995
- DE-A1- 19 633 538
- FR-A1- 2 640 077
- FR-A1- 2 786 942
- US-A- 3 727 109

## Description

La présente invention concerne un dispositif de test diélectrique de câbles pour réaliser un test sur des câbles par injection d'une tension sur lesdits câbles dans un appareillage électrique tel une cellule moyenne tension, des moyens d'injection d'une tension sur lesdits câbles par l'intermédiaire de doigts d'injection placés sur l'extrémité desdits câbles, un collecteur de terre apte à relier électriquement lesdits doigts à la terre pendant l'exploitation de la cellule et à être retiré pendant l'injection de la tension, des moyens de mise à la terre de l'appareillage et des moyens d'interverrouillage aptes à empêcher le retrait du collecteur de terre lors de la réalisation du test si l'appareillage n'est pas relié à la terre et à empêcher la déconnexion de la terre de l'appareillage après la réalisation du test si le collecteur de terre précité n'est pas remis en service pour relier à la terre lesdits doigts,

Lors de l'installation ou bien de l'exploitation d'appareillages électriques tels des cellules moyenne tension, les câbles reliant deux appareillages entre eux peuvent être dégradés, ces câbles pouvant par exemple être endommagés par une pelleteuse, etc...

De ce fait, l'exploitant doit tester son câble avec un appareil de test en injectant une tension dans le câble afin de confirmer le défaut d'isolement et de localiser le défaut pour effectuer une réparation.

Ceci est réalisé sur la cellule moyenne tension lors de la venue d'un véhicule d'intervention équipé pour réaliser des tests sur des câbles moyenne tension et, des localisations de défauts sur les câbles.

Ce test des câbles peut être réalisé sur la prise des câbles, lesquelles possèdent un bouchon qui est enlevé après la mise à la terre de l'appareillage, ou bien par l'intermédiaire de traversées spécifiques, pour le cas des câbles ne possédant pas de bouchon ou de clients ne souhaitant pas toucher le raccordement de la prise.

Dans le cas où les tests sont réalisés au moyen de traversées dédiées, un collecteur de terre relie les doigts de contact entre eux, pendant l'exploitation, ce collecteur étant retiré pour réaliser l'injection d'une tension lors des tests.

Lors de la réalisation des tests, le collecteur de terre est retiré après la mise à la terre de l'appareillage. Le montage des doigts de contact sur les traversées est réalisé pendant que la fonction sécurité terre n'est plus active, de même que la mise en place des pinces sur les doigts afin de réaliser l'injection de la tension. Ensuite, le collecteur de terre peut être mal vissé à la fin du test, ou bien l'exploitant peut avoir oublié de le raccorder sur la terre principale.

On connaît le document FR 2 786 942 décrivant un dispositif de sécurité pour un poste de distribution électrique à moyenne tension comportant des bornes auxiliaires permettant la mise en liaison des câbles d'arrivée, par l'intermédiaire de sectionneurs dûment commandés, avec des liaisons externes de mise à la terre prévues interruptibles afin de permettre la réalisation de tests.

La présente invention résout ces inconvénients et propose un dispositif pour réaliser un test diélectrique sur des câbles par injection d'une tension sur lesdits câbles, de conception simple et permettant de réaliser des tests dans des conditions de sécurité améliorées.

A cet effet, la présente invention a pour objet un dispositif de test diélectrique de câbles du genre précédemment mentionné, ce dispositif étant caractérisé en ce qu'il comporte des plots montés dans un support et reliés électriquement respectivement audits câbles, lesdits plots étant agencés de manière à pouvoir être reliés électriquement au collecteur de terre précité afin de relier les câbles à la terre préalablement à la mise en place des doigts d'injection sur les inserts de raccordement des câbles et à la mise en place des pinces d'injection sur lesdits doigts, ledit collecteur étant monté mobile dans ledit support entre une position fermée dans laquelle il relie électriquement lesdits plots entre eux afin de permettre la mise en place des doigts et des pinces et également pendant l'exploitation de l'appareillage, et une position ouverte dans laquelle il est éloigné desdits plots pour permettre l'injection de la tension.

Selon une réalisation particulière, le collecteur est monté mobile en rotation entre les deux positions précitées.

Selon une caractéristique particulière, ce collecteur comporte deux barres conductrices reliées électriquement à la terre, fixées l'une à l'autre et séparées par une certaine distance correspondant sensiblement au diamètre des plots, ledit collecteur étant monté articulé autour d'un axe dit pivot solidaire dudit support, selon un axe d'articulation s'étendant perpendiculairement à l'axe dudit axe-pivot, ledit axe-pivot et les autres plots s'étendant parallèlement les uns par rapport aux autres et étant situés dans un même plan, ledit collecteur étant mobile entre une position fermée dans laquelle les plots se trouvent enserrés entre les deux barres et sont ainsi reliés à la terre et une position ouverte dans laquelle les plots se trouvent à l'extérieur du collecteur.

Selon une autre caractéristique, des ressorts de pression de contact assurent la pression de contact entre les collecteurs et les plots par l'intermédiaire pour chaque ressort, d'une vis traversant une entretoise interposée entre les deux barres et calibrée par l'action d'un écrou à la valeur d'effort en fonction du niveau de la tenue aux courts-circuits. Ceci permet d'assurer une pression de contact sur les plots en position fermée du collecteur et permet d'évacuer le courant en cas de court-circuit.

Selon une autre caractéristique, le collecteur est manoeuvre au moyen d'une poignée.

Selon une autre caractéristique, les moyens d'inter-verrouillage précités comportent une tige comportant à l'une de ses extrémités un verrou, ladite tige étant montée en translation par rapport au support entre une première position dans laquelle le verrou bloque la rotation de la poignée et la seconde extrémité de la tige coopère avec l'arbre de manoeuvre du mécanisme de mise à la terre de l'appareillage de manière à permettre sa manoeuvre, et une seconde position dans laquelle le verrou autorise la rotation du collecteur par l'intermédiaire de la poignée et la seconde extrémité de la tige empêche la manoeuvre de l'arbre de manoeuvre du dispositif de mise à la terre de l'appareillage.

Selon une autre caractéristique, l'arbre de manoeuvre comporte un orifice destiné à autoriser l'introduction de la seconde extrémité de la tige, et en ce qu'en position de verrouillage du collecteur, le verrou est interposé entre la poignée et le collecteur et la seconde extrémité de la tige se trouve à l'extérieur de l'orifice précité autorisant de ce fait l'introduction d'un outil de manoeuvre, et en ce qu'en position déverrouillée, le verrou n'est plus interposé entre la poignée et le collecteur et la seconde extrémité de la tige est introduite dans l'orifice précité de l'arbre de manière à empêcher l'introduction d'un outil de manoeuvre de celui-ci.

Selon une autre caractéristique, ce dispositif comporte en outre des moyens pour maintenir la tige dans la position de verrouillage de la poignée.

Selon une autre caractéristique, le dispositif d'inter-verrouillage comporte également une came montée à l'extrémité d'une tige dite seconde solidaire du collecteur, ladite came coopérant avec un élément en forme de fourche monté coulissant par rapport au support et mobile par rapport audit support entre une première position dans laquelle ledit élément en forme de fourche est éloigné de la tige dite première et une position dans laquelle ledit élément coopère avec la tige de manière à empêcher le déplacement de celle-ci , la première position précitée correspondant à une position dans laquelle le collecteur est fermé et la seconde position à une position dans laquelle le collecteur est ouvert.

Selon une caractéristique particulière, l'arbre de manoeuvre comporte un orifice d'introduction d'un outil de manoeuvre et en ce que ce dernier orifice ainsi que l'orifice d'introduction de la tige prévu dans ledit arbre, sont agencés de manière à empêcher l'introduction de la tige dans cet orifice d'introduction de la tige, et donc le déverrouillage du collecteur, tant que le levier de manoeuvre n'est pas retiré.

Selon une autre caractéristique, ce dispositif comporte deux supports en forme de barres, lesdits supports assurant un maintien rigide et un positionnement précis des plots et de l'axe-pivot, lors d'un défaut en court-circuit induit par les efforts électrodynamiques.

Selon une caractéristique particulière, l'ensemble constitué par les inserts de raccordement des câbles destinés à supporter les doigts de contact, les plots, le collecteur et le dispositif d'interverrouillage est monté dans un boîtier modulaire formant support, apte à être monté dans une ouverture prévue en face avant de la cellule.

Avantageusement, ce boîtier fait office de traversée moyenne tension à travers la cloison d'une cellule et assure l'isolement diélectrique.

La présente invention a encore pour objet une cellule moyenne tension comportant un dispositif de test comportant les caractéristiques précédemment mentionnées prises seules ou en combinaison.

Mais d'autres avantages et caractéristiques de l'invention apparaîtront mieux dans la description détaillée qui suit et se réfère aux dessins annexés donnés uniquement à titre d'exemple et dans lesquels :
- La figure 1 est un schéma électrique unifilaire illustrant la fonction électrique réalisée par la cellule moyenne tension équipée d'un dispositif de test des câbles selon l'invention,
- La figure 2 est une vue en perspective d'un tableau de cellules moyenne tension destiné à être équipé en face avant d'un dispositif de test câbles selon l'invention,
- La figure 3 est une vue en perspective, illustrant le dispositif de test câble avec son dispositif d'inter-verrouillage et son raccordement sur la cuve de l'appareillage moyenne tension,
- La figure 4 est une vue partielle d'une cellule moyenne tension, illustrant plus particulièrement le raccordement des inserts de phase avec les barres du collecteur de terre,
- La figure 5 est une vue en perspective illustrant la partie intérieure du dispositif de test des câbles selon l'invention,
- La figure 6 est une vue en perspective du collecteur de terre,
- Les figures 7 et 7a sont des vues partielles en perspective, illustrant le dispositif de test des câbles et en partie le dispositif d'inter-verrouillage, dans une position de service de l'appareillage préalablement au test des câbles,
- La figure 7b est une vue partielle illustrant le dispositif de maintien du verrou en position,
- La figure 8 est une vue similaire à la précédente après la mise à la terre de l'appareillage et avant le déverrouillage du collecteur de terre, comportant le détail des interverrouillages en partie basse,
- La figure 9 est une vue similaire à la précédente après le déverrouillage du collecteur de terre, et dans une position de blocage de la position de mise à la terre de l'appareillage, avec les doigts d'injection préalablement montés,
- Les figures 10 et 10a sont des vues similaires aux précédentes, illustrant l'appareillage dans une position de test des câbles, le collecteur de terre étant enlevé des plots,

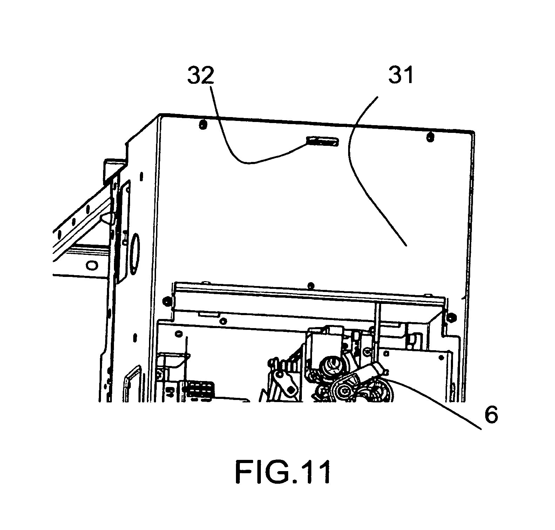

- La figure 11 est une vue partielle en perspective, similaire à la précédente, après mise en place d'un plastron.

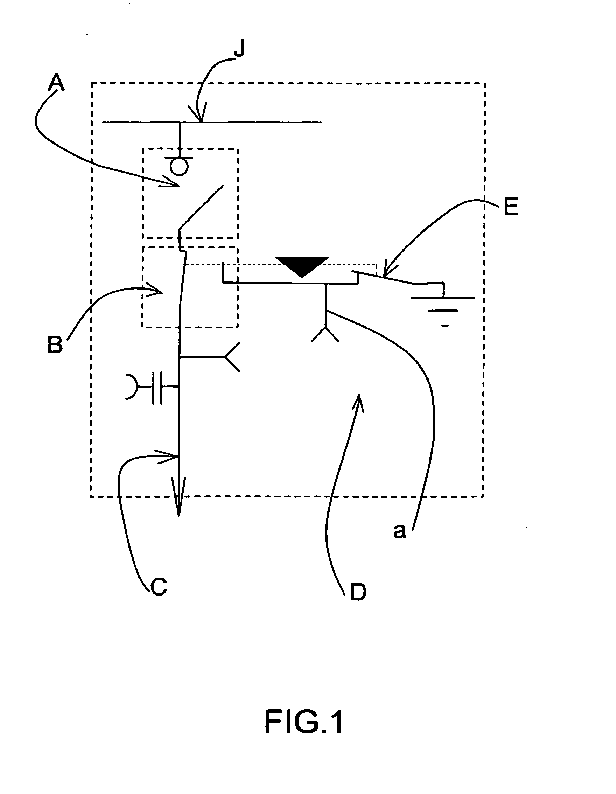

Sur la figure 1, a été représentée une cellule moyenne tension reliant électriquement un jeu de barres J à des câbles C et comportant un dispositif D de test de câbles selon l'invention. Cette cellule comprend principalement d'une part, des parties actives A comportant un interrupteur ou un disjoncteur sectionneur et d'autre part, un dispositif B de mise à la terre des câbles, le dispositif de mise à la terre pouvant être déconnecté E lors de l'injection d'une tension en un point a.

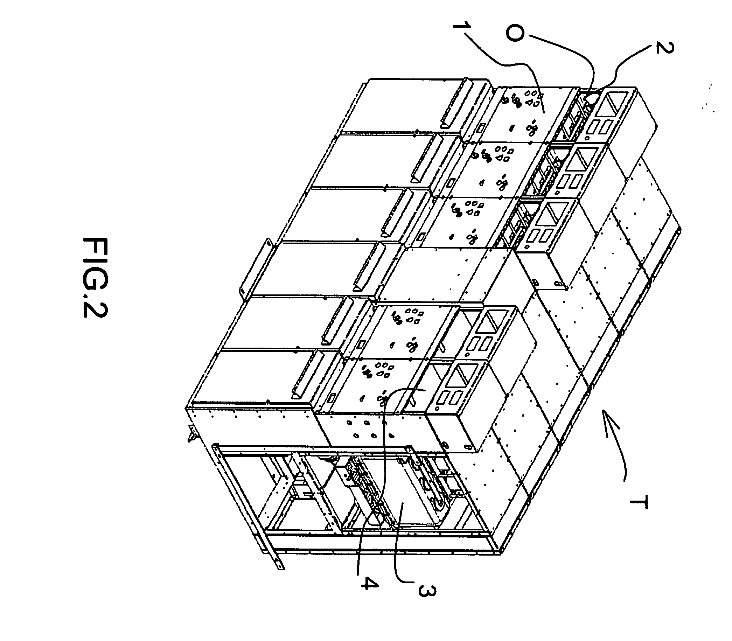

Sur la figure 2 est illustré un tableau T de cellules moyenne tension 1 comprenant un ensemble de cellules juxtaposées, chaque cellule comportant une cuve logeant des parties actives moyenne tension 3, à savoir un interrupteur ou un disjoncteur sectionneur et le sectionneur de terre. Chaque cellule 1 comporte également en face avant un logement O destiné à recevoir un dispositif de test câbles 2 ou bien un équipement basse tension 4, dans le cas ou l'on souhaite augmenter la taille de l'équipement basse tension qui se trouve au dessus.

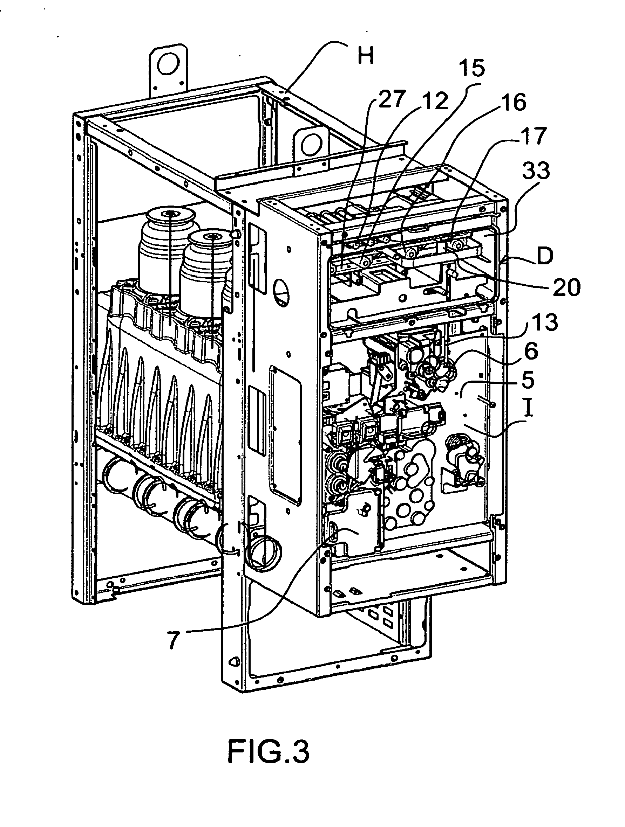

Sur la figure 3 a été représentée partiellement une cellule sur laquelle ont été retirées les parois latérales, supérieure et inférieure. L'ensemble représenté comporte donc un châssis H sur lequel est fixé le dispositif de test des câbles D et son dispositif d'interverrouillage I avec les parties actives de l'appareillage.

Sur cette figure sont représentés entre autres, un mécanisme 5 de commande du sectionneur de terre, un arbre de manoeuvre 6 du sectionneur de terre et un arbre de manoeuvre 7 de l'interrupteur ou du disjoncteur.

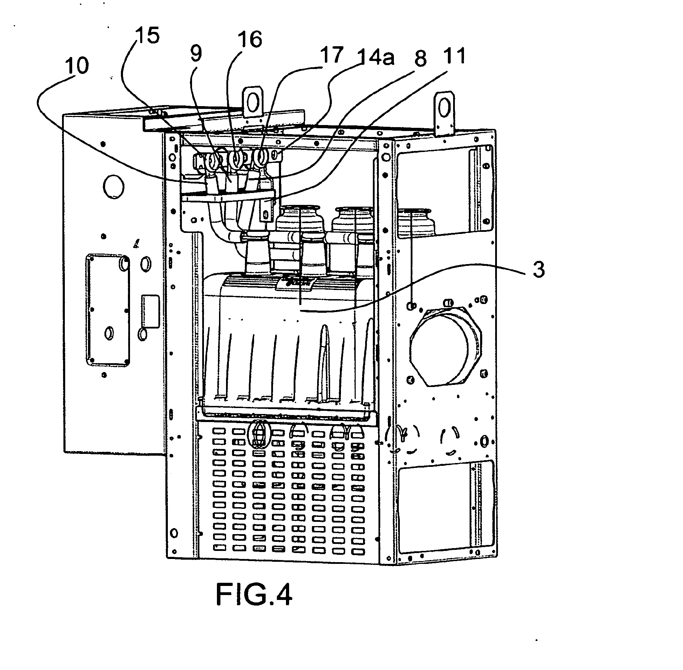

Sur la figure 4, a été représenté le raccordement des inserts de phases 15,16,17 sur les sorties 8,9,10 du sectionneur de mise à la terre, le collecteur de terre 11 du dispositif de test de câbles étant raccordé sur le collecteur de terre de l'appareillage moyenne tension.

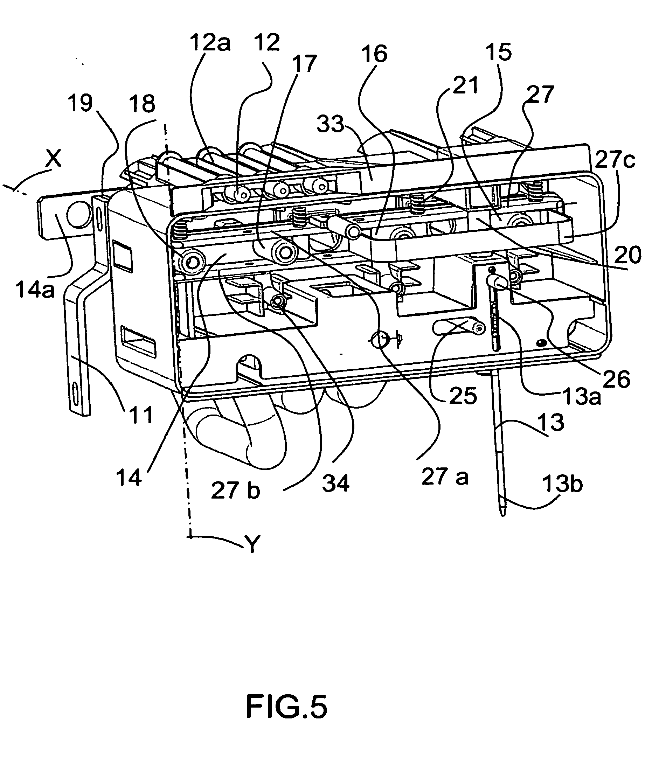

Sur la figure 5, le dispositif de test des câbles selon l'invention comporte, montés à l'intérieur d'un boîtier de forme sensiblement parallélépipédique 33, trois doigts d'injection 12 destinés à être montés sur les inserts 34 de raccordement des câbles et sur lesquels sont destinés à être montées des pinces de connexion (non représentées) de manière à réaliser un test des câbles pour la recherche de défauts sur ces câbles. Le dispositif comporte également un collecteur de terre 27 débrayable au moyen d'une poignée de manoeuvre 27c, trois inserts de raccordement à la terre 15,16 et 17 sous forme de plots respectivement destinés à mettre à la terre les trois conducteurs de phase respectivement la phase 1, la phase 2 et la phase 3, un axe-pivot 18 servant de pivot au collecteur de terre 27 et relié électriquement à la terre par un dispositif de liaison électrique, un dispositif de verrouillage 20, dit verrou, du collecteur de terre 27, des ressorts de pression de contact 21 aptes à exercer une pression sur le collecteur 27 et sur les inserts 15,16 et 17. Une première partie du dispositif d'interverrouillage I comporte le verrou 20 et une tige 13 dite d'interverrouillage, ledit verrou étant monté à l'une 13a des extrémités de ladite tige 13, ladite tige étant en liaison par sa seconde extrémité 13b avec l'arbre 6 de manoeuvre du mécanisme de commande 5 du sectionneur de mise à la terre (fig.3), ladite tige 13 étant manoeuvrée par un axe de manoeuvre 26, ladite tige 26 et le verrou 20 étant mobiles en translation entre une position haute dans laquelle le verrou 20 empêche l'ouverture du collecteur 27 et la tige 13 permet la manoeuvre de l'arbre 6 du sectionneur de terre, et une position basse dans laquelle le verrou 20 libère le collecteur 27 de manière à permettre sa rotation, et la tige 13 empêche la manoeuvre de l'arbre de manoeuvre 6 du sectionneur de terre, ladite tige 13 coopérant avec une ouverture radiale 6a prévue dans l'arbre de manoeuvre 6. Cet ensemble est logé dans le boîtier 33 supportant les fonctions diélectriques et mécaniques.

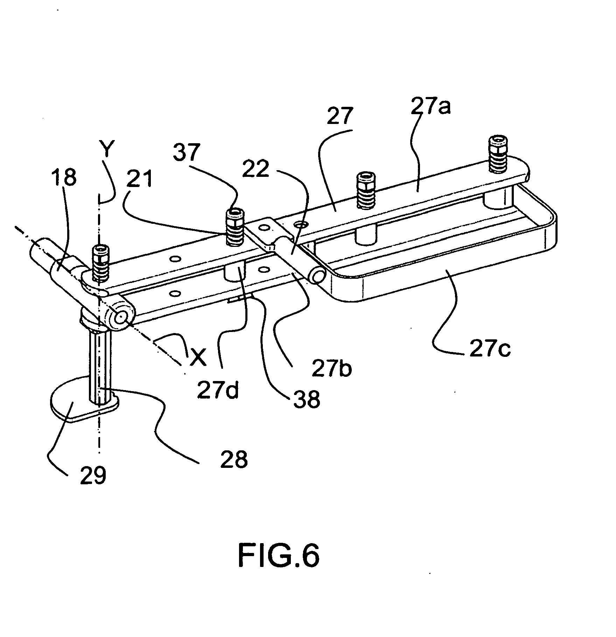

Sur la figure 6, le collecteur de terre 27 est représenté seul et comporte deux barres conductrices 27a,27b par exemple en cuivre, superposées et fixées l'une à l'autre, lesdites barres étant séparées par des entretoises 27d, la longueur de l'écartement entre les barres 27a,27b correspondant sensiblement au diamètre des inserts de phase ou plots 15,16,17 ainsi qu'au diamètre de l'axe-pivot 18.

Cet ensemble de deux barres 27a,27b est monté articulé par l'une de ses extrémités autour de l'axe-pivot précité 18 selon un axe d'articulation Y s'étendant perpendiculairement à l'axe X de l'axe-pivot précité 18. Ces deux barres sont solidaires d'une tige dite seconde 28 dont l'une des extrémités est solidarisée à une came 29 dont la fonction sera expliquée ultérieurement.

L'axe-pivot 18 est relié électriquement à la terre et le collecteur 27 peut être déplacé en rotation autour de cet axe pivot au moyen d'une poignée 27c. Un axe 22 de raccordement à la terre est également fixé sur la barre supérieure 27a et est destiné au raccordement à la masse du dispositif d'injection de tension. Des ressorts de pression de contact 21 assurent la pression de contact entre les collecteurs 27a et 27b et les plots par l'intermédiaire, pour chaque ressort, d'une vis 38 passant dans une entretoise 27d placée entre les deux barres, et calibrée par l'action de l'écrou 37 à la valeur d'effort en fonction du niveau de la tenue aux courts-circuits désirés.

On notera également que des ressorts hélicoïdaux comprimés pourraient aussi être placés entre les barres et seraient alors utilisés en traction pour réaliser la compression souhaitée. On notera également que le boîtier 33 assure aussi la fonction de traversée à travers la cloison de la cellule moyenne tension, afin de permettre le raccordement sur le sectionneur-aiguilleur, évitant ainsi tout amorçage à la terre de la cellule lors de l'opération d'injection de tension.

On notera que le support 14 assure le maintien des pièces 15,16 et 17 par l'intermédiaire de l'axe-pivot 18 avec lequel il est solidaire de même que par le boîtier 33.

Industriellement, le sous-ensemble de test de câbles se présente sous la forme d'un boîtier en kit pouvant être monté de façon modulaire par des fabricants de tableaux.

On notera que selon une réalisation particulière, le raccordement des appareils de test sur les doigts d'injection s'effectue au moyen de pinces équipées de systèmes de raccordement mâles aptes à se clipser dans un système de raccordement du type femelle de l'appareil de test.

Selon une autre réalisation non illustrée, les doigts d'injection sont équipés de systèmes de raccordement multi-contacts, lesquels s'enfichent sur les moyens de raccordement du type femelle, des appareils de test, sans pince. Ce type de raccordement direct permet d'obtenir une meilleure compacité et une meilleur tenue diélectrique.

Le fonctionnement du dispositif de test de câbles selon l'invention va être décrit dans ce qui suit en référence aux figures.

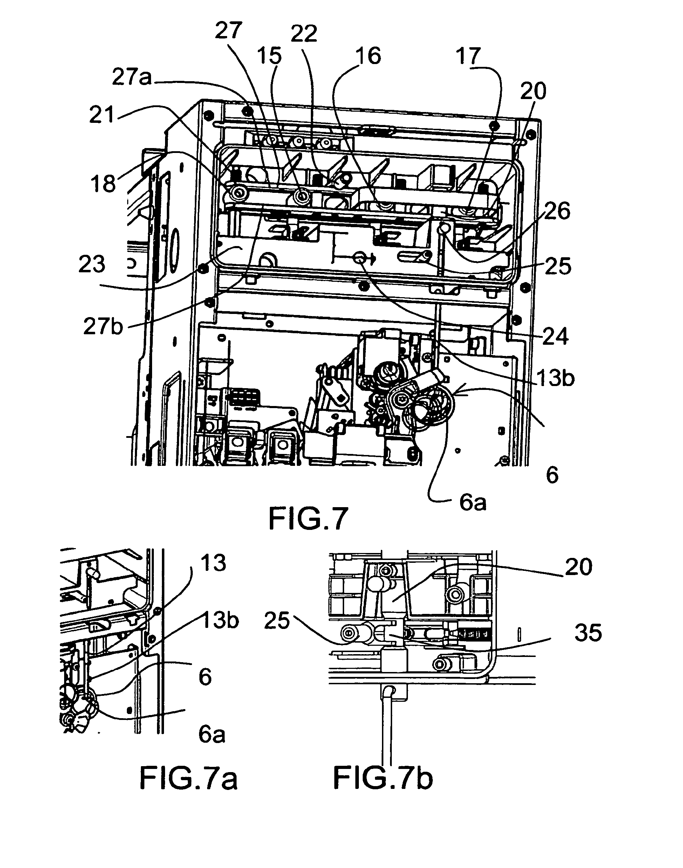

Sur la figure 7, l'appareillage est en service. Les deux barres 27a, 27b sont en position de court-circuit sur les trois inserts de terre 15,16 et 17 correspondant aux phases 1,2 et 3, de façon tangente. Afin d'évacuer le court-circuit à la terre sans délestage, quatre ressorts de pression de contact 21 appliquent un effort calibré sur les barres 27a,27b et les inserts de phase 15,16 et 17. Dans cette position, le verrou 20 est en position haute et, étant placé devant le collecteur, empêche le déplacement en rotation de ce collecteur. L'axe 26 lié au verrou 20 ne peut pas être entraîné vers le bas car l'ouverture radiale 6a de l'arbre 6 du mécanisme du sectionneur de terre ne se trouve pas en regard de l'extrémité 13b de la tige 13, d'où il résulte que la tige 13 ne peut pas être introduite dans cette ouverture radiale 6a, l'arbre 6 n'étant pas dans la bonne position angulaire correspondant à une position de mise à la terre de l'appareillage illustrée sur la figure 7a. De plus, le poussoir 25 est plaqué dans une encoche 35 prévue dans le verrou 20 de manière à maintenir ledit verrou 20 en position, comme représenté sur la figure 7b.

Selon une autre réalisation non illustrée, l'interverrouillage 25 est supprimé et est remplacé par une agrafe apte à maintenir l'axe 2 en position verrouillée. L'agrafe comporte un ressort apte à bloquer l'axe 2 dans une partie circulaire de l'agrafe en position de verrouillage du collecteur.

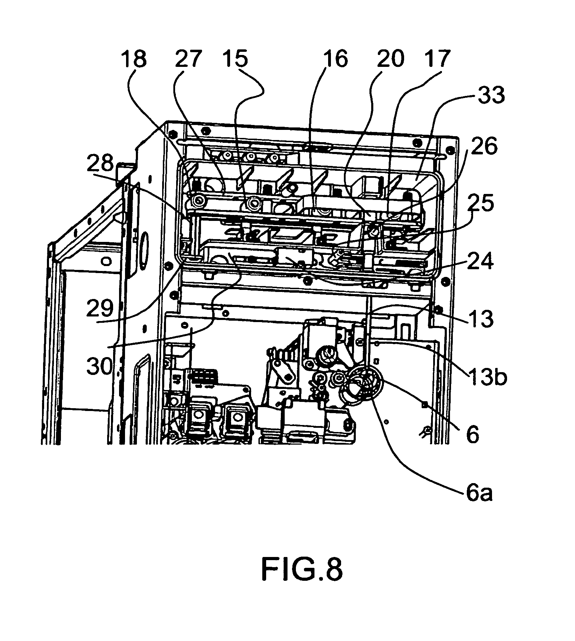

Sur la figure 8, l'appareillage est mis à la terre, ce qui a eu pour effet de permettre la rotation de l'arbre de manoeuvre 6 jusqu'à ce que l'ouverture radiale 6a de l'arbre se trouve en regard de l'extrémité 13b de la tige 13. Ceci permet l'introduction et le coulissement de cette tige à l'intérieur de cette ouverture lors de la manipulation de l'axe de manoeuvre 26 du verrou 20.

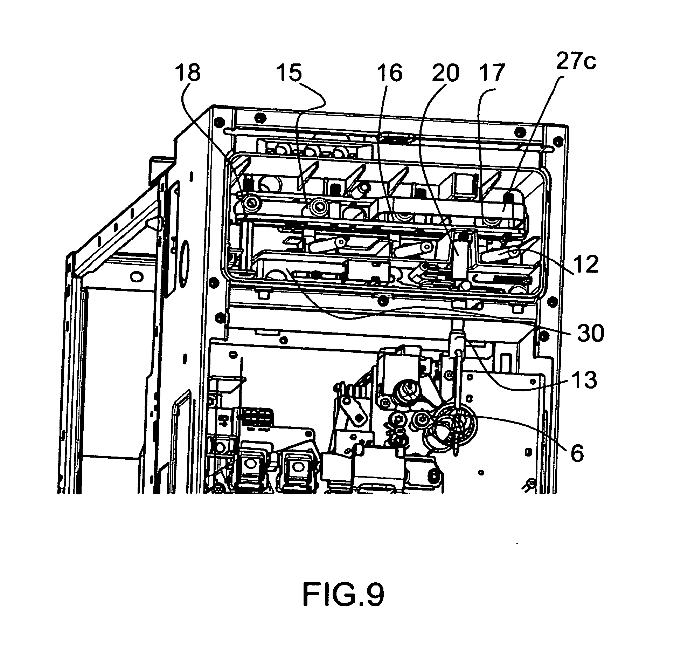

Ainsi, après l'installation des doigts d'injection, l'opérateur peut déplacer le poussoir 25 afin de faire coulisser le verrou 20 par l'intermédiaire de l'axe 26 à travers l'arbre de manoeuvre 6 du mécanisme de commande du sectionneur de terre. Ce déplacement de l'axe 26 entraîne le déplacement de la tige à travers l'orifice radial 6a de l'arbre de manoeuvre du mécanisme de commande du sectionneur de mise à la terre. La tige 13 obstrue alors l'orifice 6a de l'arbre de manoeuvre 6 empêchant de ce fait le manipulateur de manoeuvrer le sectionneur de terre, tel que ceci est illustré sur la figure 9, bloquant ce sectionneur dans la position de mise à la terre de l'appareillage.

Ce coulissement de l'axe 26 qui entraîne le verrou 20 et la tige 13 n'est possible que si l'arbre de manoeuvre 6 se trouve dans la position de mise à la terre.

Dans le cas contraire où l'appareillage est en ligne, l'orifice radial 6a de cet arbre 6 se trouve décalé angulairement et de ce fait tout mouvement de verrouillage est alors impossible. Le verrou 20 reste immobilisé empêchant l'ouverture du collecteur de terre.

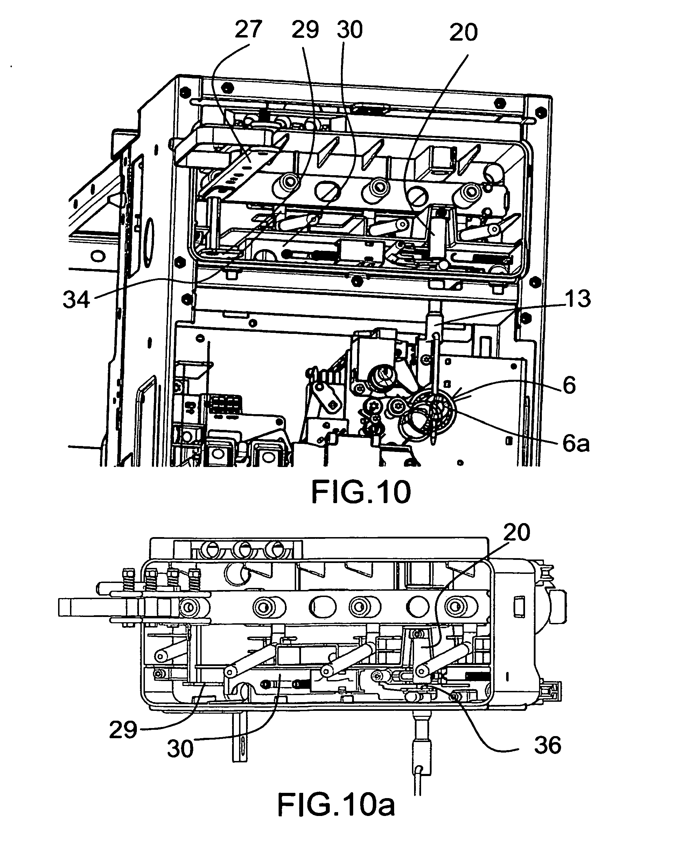

Le verrou étant en position basse, le collecteur 27 peut être entraîné en rotation autour de l'axe-pivot 18 d'un angle d'environ 90° tel qu'illustré sur la figure 10, ce qui a pour effet que le collecteur ne se trouve plus dans une position de court-circuit sur les inserts de terre des phases 1,2 et 3, lesquels ne sont plus reliés à la terre. Par ailleurs, pendant ce mouvement du collecteur 27, l'arbre 28 lié au collecteur de terre débrayable 27 et à sa poignée 27c a entraîné la came 29 dans un même mouvement de rotation. La came dans ce mouvement, coopère avec une seconde partie du dispositif d'inter-verrouillage de manière à empêcher l'actionnement du verrou 20 par l'axe 26 ainsi que de la tige 13.

De ce fait, lorsque le collecteur de terre débrayable est ouvert, la tige 13 reste présente dans l'arbre 6 et assure ainsi une position de sécurité dans laquelle l'appareil est en position de mise à la terre. Le dispositif d'inter-verrouillage assure ainsi l'immobilisation du verrou tant que le collecteur de terre n'est pas remis en court-circuit sur les trois inserts de phase. On notera également qu'un voyant mécanique 24 pourra donner une indication sur l'état de l'appareil.

Cette seconde partie du dispositif d'inter-verrouillage selon la figure 10a comporte une pièce en forme de fourchette 30 apte à coulisser par rapport au boîtier 33 entre deux positions respectivement une position dans laquelle la fourchette 30 coopère avec une seconde encoche 36 prévue dans le verrou 20 de manière à immobiliser le verrou, et une seconde position dans laquelle la fourchette 30 est éloignée du verrou de manière à permettre la manoeuvre du verrou.

Après les tests, le collecteur de terre 27 est remis en place, ce qui entraîne le déverrouillage du dispositif d'interverrouillage constitué par la came 29 et la pièce en forme de fourchette 30. Ceci permet la manoeuvre de l'axe 26 lié au verrou et à la tige 13, vers le haut de manière à verrouiller de nouveau le collecteur de terre 27. Ainsi, les pinces d'injection peuvent être déconnectées en toute sécurité de l'appareil de test et les doigts d'injection rangées. Un plastron 31 peut donc être remis en place avec possibilité de condamnation du plastron par une anse 32.

Afin de protéger la cuivrerie du collecteur de terre débrayable, le plastron 31 comporte un joint sur sa face intérieure qui est comprimé sur le rebord du boîtier thermoplastique 33. L'appareillage peut donc alors être manoeuvré pour sortir de la position à la terre par l'arbre de manoeuvre 6 et ensuite remis en ligne par l'arbre de manoeuvre 6.

L'invention est applicable particulièrement dans les cellules moyenne tension et dans tout appareillage dans lequel il est nécessaire de tester l'isolement diélectrique des câbles au moyen d'un système dédié de traversées.

On a donc réalisé grâce à l'invention un dispositif pour réaliser des tests permettant de résoudre le problème technique de la perte de la fonction terre lors de la mise en place ou du retrait des pinces lors des essais diélectriques pour contrôler l'isolement des câbles. Des interverrouillage assurent des positions définies de sécurité et de manoeuvre et une liaison mécanique avec le mécanisme de manoeuvre de la commande du sectionneur de terre de l'appareillage.

Le collecteur débrayable enlevé pendant le test est remis ensuite en place par simple rotation, le collecteur venant mettre en court-circuit les trois inserts de terre sans vissage offrant un maximum de sécurité.

Ce module de test de câbles selon l'invention peut avec un même boîtier, réaliser de la recherche de défauts de câbles, par exemple lors d'une défaillance d'isolement d'un câble, mais peut aussi être utilisé dans le but de réaliser un diagnostic de câbles à titre préventif, par exemple de type tangente delta, sans qu'il soit nécessaire de débrocher les prises moyenne tension.

Cette mesure de tangente δ est la première étape du diagnostic qui permet de donner un état global de la liaison câblée et est caractéristique de son vieillissement. Cette étape est préliminaire à la mesure des décharges partielles qui permettent de pré-localiser les éventuels points faibles du câble.

Moyennant des adaptations diélectriques et des isolations adaptées, le système peut être utilisé pour réaliser le diagnostic de câbles de type « décharges partielles ».

Bien entendu, l'invention n'est pas limitée aux modes de réalisation décrits et illustrés qui n'ont été donnés qu'à titre d'exemple.

## Revendications

1. Dispositif de test diélectrique de câbles pour réaliser un test sur des câbles par injection d'une tension sur lesdits câbles dans un appareillage électrique tel une cellule moyenne tension, des moyens d'injection d'une tension sur lesdits câbles par l'intermédiaire de doigts d'injection placés sur l'extrémité desdits câbles, un collecteur de terre apte à relier électriquement lesdits doigts à la terre pendant l'exploitation de la cellule et à être retiré pendant l'injection de la tension, des moyens de mise à la terre de l'appareillage et des moyens d'interverrouillage aptes à empêcher le retrait du collecteur de terre lors de la réalisation du test si l'appareillage n'est pas relié à la terre et à empêcher la déconnexion de la terre de l'appareillage après la réalisation du test si le collecteur de terre précité n'est pas remis en service pour relier à la terre lesdits doigts,
**caractérisé en ce qu'**il comporte des plots (15,16,17) montés dans un support (33) et reliés électriquement respectivement audits câbles, lesdits plots étant agencés de manière à pouvoir être reliés électriquement au collecteur de terre précité (27) afin de relier les câbles à la terre préalablement à la mise en place des doigts d'injection (12) sur les inserts (34) de raccordement des câbles et à la mise en place des pinces d'injection sur lesdits doigts, ledit collecteur (27) étant monté mobile dans ledit support (33) entre une position fermée dans laquelle il relie électriquement lesdits plots entre eux afin de permettre la mise en place des doigts et des pinces et également pendant l'exploitation de l'appareillage, et une position ouverte dans laquelle il est éloigné desdits plots pour permettre l'injection de la tension.

2. Dispositif de test de câbles selon la revendication 1, **caractérisé en ce que** le collecteur (27) est monté mobile en rotation entre les deux positions précitées.

3. Dispositif de test de câbles selon la revendication 1 ou 2, **caractérisé en ce que** le collecteur (27) comporte deux barres conductrices (27a,27b) reliées électriquement à la terre, fixées l'une à l'autre et séparées par une certaine distance correspondant sensiblement au diamètre des plots, ledit collecteur (27) étant monté articulé autour d'un axe dit pivot (18) solidaire dudit support (33) selon un axe d'articulation Y s'étendant perpendiculairement à l'axe X dudit axe-pivot, ledit axe-pivot (18) et les autres plots (15,16,17) s'étendant parallèlement les uns par rapport aux autres et étant situés dans un même plan, ledit collecteur (27) étant mobile entre une position fermée dans laquelle les plots se trouvent enserrés entre les deux barres et sont ainsi reliés à la terre et une position ouverte dans laquelle les plots se trouvent à l'extérieur du collecteur.

4. Dispositif de test de câbles selon la revendication 3, **caractérisé en ce que** des ressorts de pression de contact (21) assurent la pression de contact entre les collecteurs (27a, 27b) et les plots par l'intermédiaire pour chaque ressort, d'une vis (38) traversant une entretoise (27d) interposée entre les deux barres (27a,27b) et calibrée par l'action d'un écrou (37) à la valeur d'effort en fonction du niveau de la tenue aux courts-circuits.

5. Dispositif de test de câbles selon l'une quelconque des revendications 2 à 4, **caractérisé en ce que** le collecteur (27) est manoeuvrable au moyen d'une poignée (27c).

6. Dispositif de test de câbles selon la revendication 5, **caractérisé en ce que** les moyens d'interverrouillage précités (I, 20,13,30,28,29) comportent une tige (13) comportant à l'une (13a) de ses extrémités un verrou (20), ladite tige (13) étant montée en translation par rapport au support (33) entre une première position dans laquelle le verrou (20) bloque la rotation de la poignée (27c) et la seconde extrémité (13b) de la tige coopère avec l'arbre de manoeuvre (6) du mécanisme de mise à la terre de l'appareillage de manière à permettre sa manoeuvre, et une seconde position dans laquelle le verrou (20) autorise la rotation du collecteur (27) par l'intermédiaire de la poignée et la seconde extrémité (13b) de la tige empêche la manoeuvre de l'arbre de manoeuvre (6) du dispositif de mise à la terre de l'appareillage.

7. Dispositif de test de câbles selon la revendication 6, **caractérisé en ce que** l'arbre de manoeuvre (6) comporte un orifice (6a) destiné à autoriser l'introduction de la seconde extrémité (13b) de la tige, et **en ce qu'**en position de verrouillage du collecteur, le verrou (20) est interposé entre la poignée (27c) et le collecteur (27) et la seconde extrémité (13b) de la tige se trouve à l'extérieur de l'orifice précité (6a) autorisant de ce fait l'introduction d'un outil de manoeuvre, et **en ce qu'**en position déverrouillée, le verrou (20) n'est plus interposé entre la poignée (27c) et le collecteur (27) et la seconde extrémité de la tige (13) est introduite dans l'orifice précité (6a) de l'arbre (6) de manière à empêcher l'introduction d'un outil de manoeuvre de celui-ci.

8. Dispositif de test de câbles selon la revendication 7, **caractérisé en ce qu'**il comporte en outre des moyens (25) pour maintenir la tige (13) dans la position de verrouillage de la poignée (27).

9. Dispositif de test de câbles selon la revendication 6, 7 ou 8, **caractérisé en ce que** le dispositif d'interverrouillage I comporte également une came (29) montée à l'extrémité d'une tige (28) dite seconde, solidaire du collecteur (27), ladite came coopérant avec un élément en forme de fourche (30) monté coulissant par rapport au support et mobile par rapport audit support entre une première position dans laquelle ledit élément en forme de fourche est éloigné de la tige dite première (13) et une position dans laquelle ledit élément coopère avec la tige de manière à empêcher le déplacement de celle-ci , la première position précitée correspondant à une position dans laquelle le collecteur est fermé et la seconde position à une position dans laquelle le collecteur est ouvert.

10. Dispositif de test de câbles selon l'une quelconque des revendications 6 à 9, **caractérisé en ce que** l'arbre de manoeuvre comporte un orifice d'introduction d'un outil de manoeuvre et **en ce que** ce dernier orifice ainsi que l'orifice (6a) d'introduction de la tige (13) dans l'arbre de manoeuvre sont agencés de manière à empêcher l'introduction de la tige dans cet orifice d'introduction de la tige, et donc le déverrouillage du collecteur, tant que le levier de manoeuvre n'est pas retiré.

11. Dispositif de test de câbles selon l'une quelconque des revendications 3 à 10, **caractérisé en ce qu'**il comporte deux supports (14,14a) en forme de barres, lesdits supports assurant un maintien rigide et un positionnement précis des plots (15,16,17) et de l'axe-pivot (18), lors d'un défaut en court-circuit induit par les efforts électrodynamiques.

12. Dispositif de test de câbles selon l'une quelconque des revendications précédentes, **caractérisé en ce que** l'ensemble constitué par les inserts de raccordement des câbles
destinés à supporter les doigts de contact (12), les plots (15,16,17), le collecteur (27) et le dispositif d'interverrouillage I est monté dans un boîtier modulaire (33) formant support, apte à être monté dans une ouverture O prévue en face avant de la cellule.

13. Dispositif de test selon la revendication 12, **caractérisé en ce que** ce boîtier (33) fait office de traversée moyenne tension à travers la cloison d'une cellule et assure l'isolement diélectrique.

14. Cellule moyenne tension comportant un dispositif de test selon l'une quelconque des revendications précédentes.

## Claims

1. A device for performing dielectric testing of cables to perform testing on cables by inputting a voltage to said cables in an electric apparatus such as a medium-voltage cubicle, means for inputting a voltage on said cables by means of input fingers placed on the end of said cables, an earth collector designed to electrically earth said fingers during operation of the cubicle and to be removed during input of the voltage, means for earthing the apparatus and interlock means able to prevent the earth collector from being removed when testing is performed if the apparatus is not earthed and to prevent disconnection of the earth of the apparatus after testing has been performed if the above-mentioned earth collector is not put back into service to earth said fingers,
**characterized in that** it comprises studs (15,16,17) fitted in a support (33) and electrically connected respectively to said cables, said studs being arranged such as to be able to be electrically connected to the above-mentioned earth collector (27) in order to earth the cables prior to fitting of the input fingers (12) on the connection inserts (34) of the cables and to fitting of the input contact grips on said fingers, said collector (27) being mounted movable in said support (33) between a closed position in which it electrically connects said studs to one another to enable the fingers and grips to be fitted and also during operation of the apparatus, and an open position in which it is separated from said studs to enable the voltage to be input.

2. The cable testing device according to claim 1, **characterized in that** the collector (27) is mounted movable in rotation between the above-mentioned two positions.

3. The cable testing device according to claim 1 or 2, **characterized in that** the collector (27) comprises two electrically earthed conducting bars (27a,27b) fixed to one another and separated by a certain distance corresponding substantially to the diameter of the studs, said collector (27) being mounted articulated around a pin called pivot-pin (18), integral to said support (33) with an articulation axis Y extending perpendicularly to the axis X of said pivot-pin, said pivot-pin (18) and the other studs (15,16,17) extending parallel to one another and being situated in the same plane, said collector (27) being movable between a closed position in which the studs are clamped between the two bars and are thus earthed and an open position in which the studs are located outside the collector.

4. The cable testing device according to claim 3, **characterized in that** contact pressure springs (21) ensure the contact pressure between the collectors (27a, 27b) and studs by means, for each spring, of a bolt (38) passing through a spacer (27d) fitted between the two bars (27a,27b) and calibrated by the action of a nut (37) to the force value according to the short-circuit withstand level.

5. The cable testing device according to any one of claims 2 to 4, **characterized in that** the collector (27) is operable by means of a gripping handle (27c).

6. The cable testing device according to claim 5, **characterized in that** the above-mentioned interlock means (I, 20,13,30,28,29) comprise a rod (13) comprising a latch (20) at one (13a) of its ends, said rod (13) being mounted in translation with respect to the support (33) between a first position in which the latch (20) disables rotation of the handle (27c) and the second end (13b) of the rod collaborates with the operating shaft (6) of the earthing mechanism of the apparatus so as to enable operation of the latter, and a second position in which the latch (20) enables rotation of the collector (27) by means of the handle and the second end (13b) of the rod prevents operation of the operating shaft (6) of the earthing device of the apparatus.

7. The cable testing device according to claim 6, **characterized in that** the operating shaft (6) comprises an opening (6a) designed to enable insertion of the second end (13b) of the rod, and that, in the latched position of the collector, the latch (20) is interposed between the handle (27c) and the collector (27) and the second end (13b) of the rod is located outside the above-mentioned opening (6a) thereby enabling an operating tool to be inserted, and **in that** in the unlatched position, the latch (20) is no longer interposed between the handle (27c) and the collector (27) and the second end of the rod (13) is inserted in the above-mentioned opening (6a) of the shaft (6) so as to prevent insertion of an operating tool of the latter.

8. The cable testing device according to claim 7, **characterized in that** it further comprises means (25) for keeping the rod (13) in the latched position of the handle (27).

9. The cable testing device according to claim 6, 7 or 8, **characterized in that** the interlock device I also comprises a cam (29) fitted at the end of a rod (28) called second rod securedly affixed to the collector (27), said cam collaborating with a fork-shaped element (30) mounted sliding with respect to the support and movable with respect to said support between a first position in which said fork-shaped element is separated from the rod called first rod (13) and a position in which said element collaborates with the rod so as to prevent movement of the latter, the above-mentioned first position corresponding to a position in which the collector is closed and the second position to a position in which the collector is open.

10. The cable testing device according to any one of claims 6 to 9, **characterized in that** the operating shaft comprises an opening for insertion of an operating tool and that the latter opening and the opening (6a) for insertion of the rod (13) in the operating shaft are arranged in such a way as to prevent insertion of the rod in this opening for insertion of the rod, thereby preventing unlatching of the collector, so long as the operating lever has not been removed.

11. The cable testing device according to any one of claims 3 to 10, **characterized in that** it comprises two supports (14,14a) in the form of bars, said supports ensuring rigid securing and precise positioning of the studs (15,16,17) and of the pivot-pin (18) when a short-circuit fault occurs induced by the electrodynamic forces.

12. The cable testing device according to any one of the foregoing claims, **characterized in that** the assembly formed by the connection inserts of the cables designed to support the contact fingers (12), studs (15,16,17), collector (27) and interlock device I is fitted in a modular case (33) forming a support, able to be fitted in an opening O provided on the front panel of the cubicle.

13. The cable testing device according to claim 12, **characterized in that** the case (33) acts as medium-voltage bushing through the partitioning wall of a cubicle and performs dielectric insulation.

14. A medium-voltage cubicle comprising a testing device according to any one of the foregoing claims.

## Patentansprüche

1. Vorrichtung zur Isolationsprüfung von Kabeln zur Realisierung einer Kabelprüfung durch Einleitung einer Spannung in die genannten Kabel eines elektrischen Schaltgeräts wie beispielsweise einer Mittelspannungs-Schaltzelle, Mittel zur Einleitung einer Spannung in die genannten Kabel über auf die Kabelenden geführte Prüfspitzen, Erdungssammelschiene, zur Erdung der genannten Prüfspitzen während des Betriebs der Schaltzelle, welche Schiene bei Einleitung der Prüfspannung zurückgezogen werden kann, Mittel zur Erdung des elektrischen Schaltgeräts sowie Mittel zur gegenseitigen Verriegelung, die dazu ausgelegt sind, bei Durchführung der Isolationsprüfung ein Zurückziehen der Erdungssammelschiene zu verhindern, wenn das Schaltgerät nicht geerdet ist, sowie nach erfolgter Isolationsprüfung die Unterbrechung der Erdungsverbindung des Schaltgeräts zu verhindern, wenn die genannte Erdungssammelschiene nicht in die Betriebsstellung mit Erdung der genannten Prüfspitzen zurückgeführt worden ist,
**dadurch gekennzeichnet, dass** die Vorrichtung in einem Träger (33) montierte und mit den genannten Kabeln verbundene Kontaktbolzen (15, 16, 17) umfasst, welche Bolzen so aus- gebildet sind, dass sie zur Erdung der Kabel vor dem Anlegen der Prüfspitzen (12) an die Kabelanschlusseinsätze (34) und vor dem Anbringen der Prüfzangen auf den genannten Prüfspitzen mit der genannten Erdungssammelschiene (27) verbunden werden können, wobei die genannte Erdungssammelschiene (27) beweglich auf dem genannten Träger (33) gelagert ist und zwischen einer Einschaltstellung, in der sie die genannten Kontaktbolzen zum Anbringen der Prüfspitzen und der Prüfzangen sowie im Betrieb des Schaltgeräts elektrisch miteinander verbindet, sowie einer Ausschaltstellung verschoben werden kann, in der sie von den genannten Kontaktbolzen zurückgezogen ist, um die Einleitung der Prüfspannung zu ermöglichen.

2. Kabelprüfvorrichtung nach Anspruch 1, **dadurch gekennzeichnet, dass** die Erdungssammelschiene (27) drehwirksam zwischen den beiden genannten Stellungen verschoben werden kann.

3. Kabelprüfvorrichtung nach Anspruch 1 oder 2, **dadurch gekennzeichnet, dass** die Erdungssammelschiene (27) zwei Leiterschienen (27a, 27b) umfasst, die elektrisch mit Erde verbunden sowie aneinander befestigt und durch einen bestimmten, annähernd dem Durchmesser der Kontaktbolzen entsprechenden Abstand voneinander getrennt sind, welche Erdungssammelschiene (27) an einen, am genannten Träger (33) befestigten sogenannten Drehgelenkzapfen (18) angelenkt ist und eine Drehachse Y aufweist, die senkrecht zur Achse X des genannten Drehgelenkzapfens verläuft, wobei der Drehgelenkzapfen (18) sowie die übrigen Kontaktbolzen (15, 16, 17) parallel zueinander, in der gleichen Ebene angeordnet sind und die genannte Erdungssammelschiene (27) zwischen einer Einschaltstellung, in der die Kontaktbolzen zwischen den beiden Schienen eingeklemmt und dadurch mit Erde verbunden sind, sowie einer Ausschaltstellung verschoben werden kann, in der die Kontaktbolzen außerhalb der Kontur der Erdungssammelschiene liegen.

4. Kabelprüfvorrichtung nach Anspruch 3, **dadurch gekennzeichnet, dass** die Kontaktdruckfedern (21) den Kontaktdruck zwischen den Erdungsschienen (27a, 27b) und den Kontaktbolzen mithilfe von Schrauben (38) gewährleisten, die an jeder Feder durch eine zwischen den Schienen (27a, 27b) angeordnete Abstandshülse (27d) geführt und über eine Mutter (37) auf die Kontaktkraft in Abhängigkeit von der jeweiligen Kurzschlussfestigkeit eingestellt sind.

5. Kabelprüfvorrichtung nach irgendeinem der Ansprüche 2 bis 4, **dadurch gekennzeichnet, dass** die Erdungssammelschiene (27) mithilfe eines Handgriffs (27c) verschwenkt werden kann.

6. Kabelprüfvorrichtung nach Anspruch 5, **dadurch gekennzeichnet, dass** die genannten Mittel zur gegenseitigen Verriegelung (I, 20, 13, 30, 28, 29) eine Stange (13) umfassen, an deren einem Ende (13a) ein Riegel (20) ausgebildet ist, welche Stange (13) so gelagert ist, dass sie in Bezug zum Träger (33) zwischen einer ersten Stellung, in welcher der Riegel (20) ein Verschwenken des Handgriffs (27c) blockiert und das zweite Ende (13b) der Stange so mit der Schaltwelle (6) der Erdungsvorrichtung des Schaltgeräts zusammenwirkt, dass diese Welle betätigt werden kann, sowie einer zweiten Stellung geradlinig verschoben werden kann, in welcher der Riegel (20) ein Verschwenken der Erdungssammelschiene durch Betätigung des Handgriffs (27c) erlaubt und das zweite Ende (13b) der Stange eine Betätigung der Schaltwelle der Erdungsvorrichtung des Schaltgeräts verhindert.

7. Kabelprüfvorrichtung nach Anspruch 6, **dadurch gekennzeichnet, dass** in der Schaltwelle (6) eine Öffnung (6a) ausgebildet ist, die dazu dient, die Einführung des zweiten Endes (13b) der Stange zu ermöglichen, dass in der Verriegelungsstellung der Erdungssammelschiene der Riegel (20) zwischen dem Handgriff (27c) und der Erdungssammelschiene (27) angeordnet ist und das zweite Ende (13b) der Stange sich außerhalb der genannten Öffnung (6a) befindet, so dass die Einführung eines Betätigungswerkzeugs möglich ist, und dass in der Entriegelungsstellung der Riegel (20) nicht mehr zwischen dem Handgriff (27c) und der Erdungssammelschiene (27) angeordnet ist und das zweite Ende der Stange (13) in die genannte Öffnung (6a) der Schaltwelle (6) eingreift, so dass die Einführung eines Werkzeugs zur Betätigung der genannten Welle verhindert wird.

8. Kabelprüfvorrichtung nach Anspruch 7, **dadurch gekennzeichnet, dass** sie zusätzlich Mittel (25) umfasst, um die Stange (13) in der Verriegelungsstellung des Handgriffs (27c) zu halten.

9. Kabelprüfvorrichtung nach Anspruch 6, 7 oder 8, **dadurch gekennzeichnet, dass** die Vorrichtung zur gegenseitigen Verriegelung außerdem eine Steuerkurve (29) umfasst, die am Ende einer, mit der Erdungssammelschiene (27) verbundenen, sogenannten zweiten Stange (28) montiert ist und mit einem gabelförmigen Element (30) zusammenwirkt, welches Element in Bezug zum Träger gleitend gelagert ist und darin zwischen einer ersten Stellung, in der das genannte gabelförmige Element von der sogenannten ersten Stange (13) zurückgezogen ist, und einer Stellung verschoben werden kann, in welcher das genannte Element mit der Stange zusammenwirkt, derart dass ein Verschieben dieser Stange verhindert wird, wobei die genannte erste Stellung einer Stellung entspricht, in der die Erdungssammelschiene geschlossen ist, und die zweite Stellung einer Stellung entspricht, in der die Erdungssammelschiene geöffnet ist.

10. Kabelprüfvorrichtung nach irgendeinem der Ansprüche 6 bis 9, **dadurch gekennzeichnet, dass** die Schaltwelle eine Öffnung zur Einführung eines Betätigungswerkzeugs umfasst und dass diese Öffnung sowie die Öffnung (6a) zur Einführung der Stange (13) in die Schaltwelle so ausgebildet sind, dass eine Einführung der Stange in diese zur Einführung der Stange bestimmte Öffnung und somit die Entriegelung der Erdungssammelschiene verhindert wird, solange der Betätigungshebel nicht abgezogen ist.

11. Kabelprüfvorrichtung nach irgendeinem der Ansprüche 3 bis 10, **dadurch gekennzeichnet, dass** sie zwei schienenförmige Träger (14,14a) umfasst, welche Träger bei Auftreten eines durch elektrodynamische Kräfte verursachten Kurzschlusses eine feste Halterung und eine genaue Positionierung der Kontaktbolzen (15, 16, 17) und des Drehgelenkzapfens (18) gewährleisten.

12. Kabelprüfvorrichtung nach irgendeinem der vorhergehenden Ansprüche, **dadurch gekennzeichnet, dass** die aus den zur Abstützung der Kontaktfinger (12) bestimmten Kabelanschlusseinsätzen, den Kontaktbolzen (15, 16, 17), der Erdungssammelschiene (27) und der Vorrichtung zur gegenseitigen Verriegelung I bestehende Baueinheit in einem als Tragkonstruktion dienenden modularen Gehäuse (33) angeordnet ist, welches in eine an der Vorderseite der Schaltzelle ausgebildete Öffnung eingesetzt werden kann.

13. Prüfvorrichtung nach Anspruch 12, **dadurch gekennzeichnet, dass** das genannte Gehäuse (33) als Mittelspannungs-Durchführung durch die Trennwand einer Schaltzelle dient und die elektrische Isolation gewährleistet.

14. Mittelspannungs-Schaltzelle mit einer Prüfvorrichtung nach irgendeinem der vorhergehenden Ansprüche.
